# EUROPEAN PATENT APPLICATION

(11) **EP 1 394 847 A1**
(43) Date of publication of application: **03.03.2004**
(21) Application number: 01936871.1
(22) Date of filing: 06.06.2001
(51) Int. Cl.: H01L 21/66, G01R 1/073

(54) **WAFER PROBER**

(71) Applicant: Ibiden Co., Ltd., Ogaki-shi, Gifu 503-0917 (JP)
(72) Inventor: ITO, Atsushi, Ibi-gun, Gifu 501-0695 (JP); HIRAMATSU, Yasuji, Ibi-gun, Gifu 501-0695 (JP); ITO, Yasutaka, Ibi-gun, Gifu 501-0695 (JP)
(74) Representative: Forstmeyer, Dietmar, Dr. rer. nat., Dipl.-Chem.
(86) International application number: PCT/JP2001/004775
(87) International publication number: WO 2002/101816

(57) **Abstract**

An obj ect of the present invention is to provide a wafer prober capable of protecting a chuck top conductor layer against noises, preventing integrated circuits and the like from erroneously operating due to the noises, and precisely determining whether or not the integrated circuits and the like normally operate. The present invention provides a wafer prober comprising: a ceramic substrate and a chuck top conductor layer formed on a main face of said ceramic substrate; and a guard electrode formed inside of said ceramic substrate, wherein a metal layer is formed on a side face of said ceramic substrate.

## Description

### Technical Field

The present invention relates to a wafer prober used mainly in the semiconductor industry, and more particularly to a wafer prober which is thin, light and excellent in temperature-rising and temperature-dropping property.

### Background Art

Semiconductors are very important goods necessary in various industries. A semiconductor chip is produced, for example, by slicing a silicon monocrystal into a given thickness to produce a silicon wafer, and then forming various circuits and so forth on this silicon wafer.

In this process for producing semiconductor chips, at a stage before a silicon wafer is cut to be divided into the respective semiconductor chips, a probing step of checking whether or not the electric property thereof acts as designed is necessary. For this purpose, the so-called prober is used.

As such a prober, for example, Japanese Patent gazette No. 2587289, JP Kokoku Hei 3-40947, JP Kokai Hei 11-31724 and the like disclose wafer probers having a chuck top made of a metal such as aluminum alloy or stainless steel.

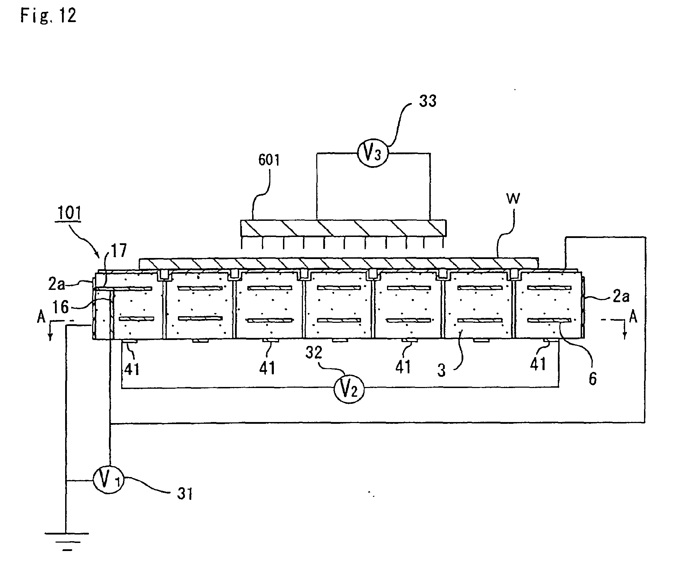

About such a wafer prober, for example, as shown in Fig. 12, a silicon wafer W is put on a wafer prober 101, and a probe card 601 having tester pins are pressed against this silicon wafer W to apply a voltage thereto while the wafer is heated or cooled. In this way, a continuity test is performed.

In Fig. 12, V₃ represents a power source 33 for applying a voltage to the probe card 601, V₂ represents a power source 32 for applying a voltage to heating elements 41, and V₁ represents a power source 31 for applying a voltage to a chuck top conductor layer 2 and guard electrodes 5. This power source 31 is also connected to ground electrodes 6 and earthed.

### Summary of the Invention

However, wafer probers having such a metal chuck top have the following problems.

Firstly, since the chuck top is made of a metal, it is unavoidable to make the thickness of the chuck top as thick as about 15 mm. The reason why the chuck top is made thick in this way is that in the case of a thin metal, the chuck top is pressed by the tester pins of the probe card and thus the metal plate of the chuck top is warped or distorted so that a silicon wafer put on the metal plate is damaged or inclined.

It is therefore necessary to make the chuck top thick. As a result, however, problems are caused: the weight of the chuck top gets large and the volume thereof also becomes large.

Although the metal, which has a high thermal conductivity, is used, the temperature-rising and temperature-dropping property is bad and the temperature of the chuck top plate does not follow a change in voltage or electric current quantity promptly, causing problems that the temperature thereof is not easily controlled and when a silicon wafer is put thereon at a high temperature, the temperature cannot be controlled.

The present inventors made eager investigations in order to solve the above-mentioned problems. As a result, the present inventors thought of an idea of: using a ceramic having high rigidity as a substrate, instead of a metal chuck top; then forming a conductor layer as a chuck top conductor layer on the surface thereof; and further forming guard electrodes for canceling a stray capacitor originating from a high dielectric constant of this ceramic substrate.

However, only by forming the guard electrodes, it is difficult to prevent noises generated from heating elements and the like from producing a large effect on the guard electrodes. Therefore, when a continuity test for a silicon wafer is performed, the noises may cause an erroneous operation in integrated circuits and the like. Accordingly, a correct determination may not be made on the basis of the continuity test.

Thus, the present inventors made further investigations. As a result, the present inventors have found out that, by forming a metal layer on a side face of a prober, it becomes possible to prevent integrated circuits from erroneously operating due to noises, and to precisely determine by a continuity test whether or not the integrated circuits normally operate. Thus, the present invention has been completed.

A wafer prober according to the present invention comprises: a ceramic substrate; a chuck top conductor layer formed on a main face of the above-mentioned ceramic substrate; and a guard electrode formed inside of the above-mentioned ceramic substrate, wherein
ametal layer is formed on a side face of the above-mentioned ceramic substrate.

### Brief Description of the Drawings

Fig. 1 is a sectional view which schematically shows an example of the wafer prober of the present invention.
Fig. 2 is a plan view of the wafer prober shown in Fig. 1.
Fig. 3 is a bottom view of the wafer prober shown in Fig. 1.
Fig. 4 is a sectional view taken along A-A line of the wafer prober shown in Fig. 1.
Fig. 5 is a sectional view which schematically shows an example of the wafer prober of the present invention.
Fig. 6 is a sectional view which schematically shows an example of the wafer prober of the present invention.
Fig. 7 is a sectional view which schematically shows an example of the wafer prober of the present invention.
Fig. 8 is a sectional view which schematically shows a case where a wafer prober of the present invention is combined with a supporting case.
Fig. 9 (a) is a vertical sectional view which schematically shows a case where a wafer prober of the present invention is combined with another supporting case, and Fig. 9(b) is a sectional view taken along B-B line thereof.
Figs. 10 (a) to (d) are sectional views which schematically show parts of the process for producing a wafer prober of the present invention.
Figs. 11 (e) to (g) are sectional views which schematically show parts of the process for producing the wafer prober of the present invention.
Fig. 12 is a sectional view which schematically shows a state that the wafer prober of the present invention is used to perform a continuity test.

### Explanation of Symbols

- 101, 201, 301, 401: wafer prober
- 2: chuck top conductor layer
- 2a: side face conductor layer
- 3: ceramic substrate
- 5: guard electrode
- 6: ground electrode
- 7: groove
- 8: suction hole
- 10: heat insulating material
- 11: supporting case
- 12: coolant outlet
- 13: inhalation duct
- 14: coolant inlet
- 15: supporting column
- 16, 18: conductor filled through hole
- 17: connecting portion
- 180: blind hole
- 19, 190: external terminal pin
- 41, 42: heat element
- 410: protective layer
- 43: metal wire
- 44: Peltier device
- 440: thermoelectric element
- 441: ceramic substrate
- 51: conductor layer
- 52: non conductor formed portion

### Detailed Disclosure of the Invention

A wafer prober according to the present invention comprises: a ceramic substrate and a chuck top conductor layer formed on a main face of the above-mentioned ceramic substrate; and a guard electrode formed inside of the above-mentioned ceramic substrate, wherein
a metal layer is formed on a side face of the above-mentioned ceramic substrate.

In the present invention, the metal layer is formed on the side face of the ceramic substrate, and the metal layer is connected to the guard electrode. Therefore, it is possible to prevent noises generated from heating elements and the like from going round from the side face of the ceramic substrate to the outside to reach the chuck top conductor layer; prevent an erroneous operation of integrated circuits which results from the noises; and determine whether or not the integrated circuits operate normally by a continuity test.

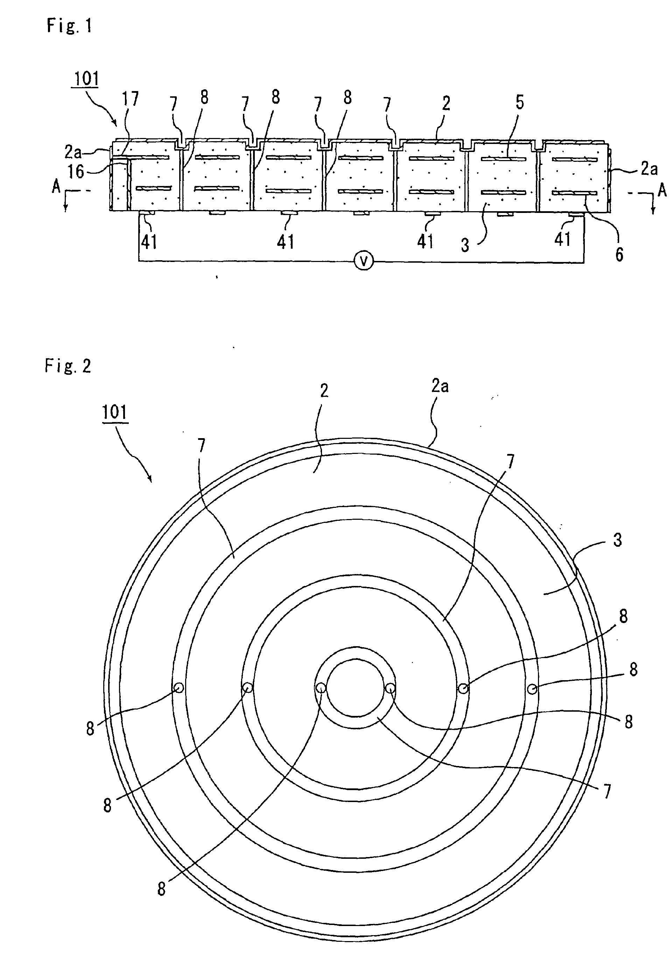

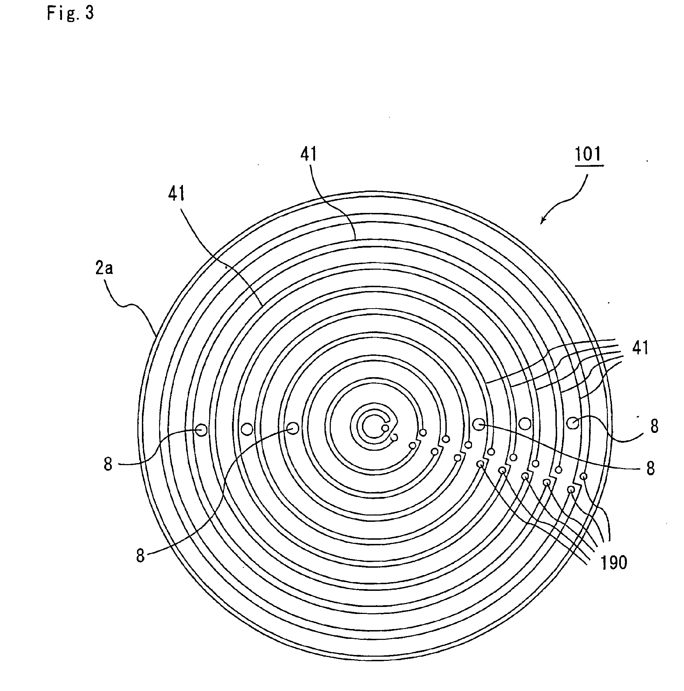

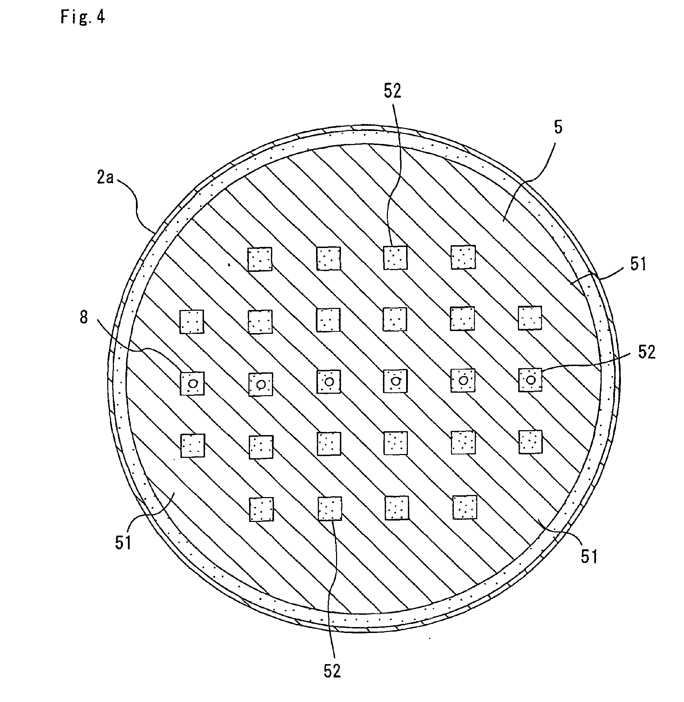

Fig. 1 is a sectional view which schematically shows an embodiment of the wafer prober of the present invention, Fig. 2 is a plan view thereof, Fig. 3 is a bottom view thereof, and Fig. 4 is a sectional view taken along A-A line in the wafer prober shown in Fig. 1.

In this wafer prober 101, concentrically circular grooves 7 are made in a surface of a ceramic substrate 3, which is in a circular form when viewed in plan, and further suction holes 8 for sucking a silicon wafer are made in some portions of the grooves 7. A chuck top conductor layer 2 for connecting electrodes of the silicon wafer is formed, in a circular form, on most of the ceramic substrate 3 including the grooves 7.

On the other hand, heating elements 41, which are in a concentrically circular form as shown in Fig. 3 when viewed in plan, are formed on the bottom face of the ceramic substrate 3 in order to control the temperature of the silicon wafer. External terminal pins 190 are connected and fixed to both ends of the heating element 41, and guard electrodes 5 and ground electrodes 6 are positioned inside the ceramic substrate 3 in order to remove stray capacitors or noises.

A metal layer 2a is formed on side faces of the ceramic substrate 3, and this metal layer 2a is connected to the guard electrodes 5. As a result, the resistance heating elements 41 are surrounded by the guard electrodes 5 and the metal layer (conductor layer) 2a on the side faces. It is therefore possible to surely prevent erroneous operation of integrated circuits and the like which results from noises generated from the resistance heating elements 41 and the like.

The wafer prober of the present invention has a structure as shown in Figs. 1 to 4. The following will successively describe respective members constituting the above-mentioned wafer prober, and other embodiments of the wafer prober of the present invention in detail.

The ceramic material used in the wafer prober of the present invention is desirably at least one selected from nitride ceramics, carbide ceramics, and oxide ceramics.

Examples of the nitride ceramics include metal nitride ceramics such as aluminum nitride, silicon nitride, boron nitride, titanium nitride and the like.

Examples of the carbide ceramics include metal carbide ceramics such as silicon carbide, zirconium carbide, titanium carbide, tantalum carbide, tungsten carbide and the like.

Examples of the oxide ceramics include metal oxide ceramics such as alumina, zirconia, cordierite, mullite and the like.

These ceramics may be used alone or in combination of two or more thereof.

Among these ceramics, the nitride ceramics and the carbide ceramics are more preferred than the oxide ceramics since the former have a high thermal conductivity.

Aluminum nitride is most preferred among the nitride ceramics since its thermal conductivity is highest, that is, 180 W/m·K.

It is desired that 100 to 2000 ppm of carbon is contained in the above-mentioned ceramic, this is because an electrode pattern inside the ceramic can be hidden and high radiation heat can be obtained. The carbon may be either in a crystal form which can be detected by X-ray analysis or in an amorphous form which cannot be detected, or may be both thereof.

It is necessary that the thickness of the ceramic substrate of the chuck top in the present invention is larger than that of the chuck top conductor layer. Specifically, the thickness thereof is desirably from 1 to 10 mm.

In the present invention, the back face of a silicon wafer is used as an electrode. Accordingly, on one main face of a ceramic substrate is formed a chuck top conductor layer, and on a side face of the ceramic substrate is a metal layer (hereinafter, may be referred to as side face conductor layer) connected to guard electrodes.

The thickness of the chuck top conductor layer and the side face conductor layer is desirably from 1 to 20 µm. If the thickness is less than 1 µm, its resistance value is too high so that the layers do not function as electrodes. On the other hand, if the thickness exceeds 20 µm, the layers exfoliate easily by stress that the conductor has.

As the chuck top conductor layer and the side face conductor layer, there can be used, for example, at least one metal selected fromhighmeltingpointmetals such as copper, titanium, chromium, nickel, noble metals (gold, silver, platinum and the like), tungsten, molybdenum and the like.

The chuck top conductor layer or the side face conductor layer may be a porous body comprising a metal or a conductive ceramic. When the chuck top conductor layer is made of the porous body, it is unnecessary to make grooves for suction or adsorption as described later and thus it is possible to prevent the wafer from being damaged because of the grooves. Additionally, the whole of the surface can realize uniform suction and adsorption.

As such a porous body, a metal sintered body can be used.

In the case where the porous body is used, the thickness thereof can be set to 1 to 200 µm. To bond the porous body to the ceramic substrate, solder or brazing material is used.

The chuck top conductor layer and the side face conductor layer desirably contain nickel. This is because nickel has a high hardness and in the case of the chuck top conductor layer, the layer is not easily deformed or the like against the pressing pressure by tester pins.

Specific examples of the structure of the chuck top conductor layer and the side face conductor layer include: a structure obtained by forming a nickel sputtering layer firstly and then depositing an electroless nickel plating layer thereon; a structure obtained by sputtering titanium, molybdenum and nickel in this order and then precipitating nickel thereon by electroless plating or electroplating; and the like.

It is allowable to use a structure obtained by sputtering titanium, molybdenum and nickel in this order and then precipitating copper and nickel thereon by electroless plating. This is because the formation of the copper layer causes a decrease in the resistance value of the chuck top electrode.

Furthermore, it is allowable to use a structure obtained by sputtering titanium and copper in this order and then precipitating nickel thereon by electroless plating or electroplating.

It is also allowable to use a structure obtained by sputtering chromium and copper in this order and then precipitating nickel thereon by electroless plating or electroplating.

The titanium and chromium can cause an improvement in adhesion to the ceramic, and molybdenum can cause an improvement in adhesion to nickel.

The thickness of the titanium or chromium is desirably from 0.1 to 0. 5 µm, the thickness of the molybdenum is desirably from 0.5 to 7. 0 µm, and the thickness of the nickel is desirably from 0.4 to 2.5 µm.

It is desirable to form a noble metal layer (gold, silver, platinum or palladium) on the surfaces of the chuck top conductor layer and the side face conductor layer.

This is because the noble metal layer can prevent contamination based on the migration of a base metal. The thickness of the noble metal layer is desirably from 0.01 to 15 µm.

In the present invention, it is desirable to provide temperature controlling means to the ceramic substrate since a continuity test for a silicon wafer can be made while the wafer is heated or cooled.

The temperature controlling means may be the heating element 41 shown in Fig. 1, or a Peltier device. When the heating element is equipped, an outlet for a coolant such as air, or some other means may be equipped, as cooling means, to a device to which the wafer prober is fitted.

The heating element may be composed of plural layers. In this case, it is desirable that the patterns of the respective layers may be formed to complement them mutually in the state that the patterns are formed on any one of the layers when the patterns are viewed from the heating face. For example, a structure having a staggered arrangement is desirable.

Examples of the heating element include: a sintered body of a metal or a conductive ceramic; a metal foil; a metal wire; and the like. As the metal sintered body, at least one selected from tungsten andmolybdenum is preferred. This is because these metals are not relatively liable to be oxidized and have a resistance value sufficient to generate heat.

As the conductive ceramic, at least one selected from carbides of tungsten and molybdenum may be used.

In the case where the heating element is formed on the outside of the ceramic substrate, it is desired to use, as the metal sintered body, a noble metal (gold, silver, palladium or platinum) or nickel. Specifically, silver, silver-palladium and the like may be used.

As metal particles used in the metal sintered body, spherical or scaly particles, or a mixture of spherical particles and scaly particles can be used.

A metal oxide may be added to the metal sintered body. The metal oxide is used in order to adhere the nitride ceramic or carbide ceramic closely to particles of the metal. The reason why the adhesion between the nitride ceramic or carbide ceramic and the metal particles is improved by the metal oxide is unclear, but can be considered as follows: oxide films are slightly formed on the surface of the metal particles and the surface of the nitride ceramic or carbide ceramic, and these oxide films are sintered and integrated with each other, through the metal oxide, so that the metal particles adhere closely to the nitride ceramic or carbide ceramic.

A preferred example of the above-mentioned metal oxide is at least one selected from lead oxide, zinc oxide, silica, boron oxide (B₂O₃), alumina, yttria,' and titania. These oxides make it possible to improve adhesion between the metal particles and the nitride ceramic or carbide ceramic without increasing the resistance value of the heating element.

The amount of the above-mentioned metal oxide(s) is desirably 0.1% or more by weight and is less than 10% by weight of the metal particles. This is because this makes it possible to improve the adhesion between the metal particles and the nitride ceramic or carbide ceramic without making the resistance value too large.

When the total amount of the metal oxides is set to 100 parts by weight, theproportionsofleadoxide, zincoxide, silica, boron oxide (B₂O₃), alumina, yttria and titania are as follows: lead oxide: 1 to 10 parts by weight, silica: 1 to 30 parts by weight, boron oxide: 5 to 50 parts by weight, zinc oxide: 20 to 70 parts by weight, alumina: 1 to 10 parts by weight, yttria: 1 to 50 parts by weight and titania: 1 to 50 parts by weight. The proportions are preferably adjusted within the scope that the total amount of these oxides is not more than 100 parts by weight. This is because these ranges improve adhesion particularly to the nitride ceramic.

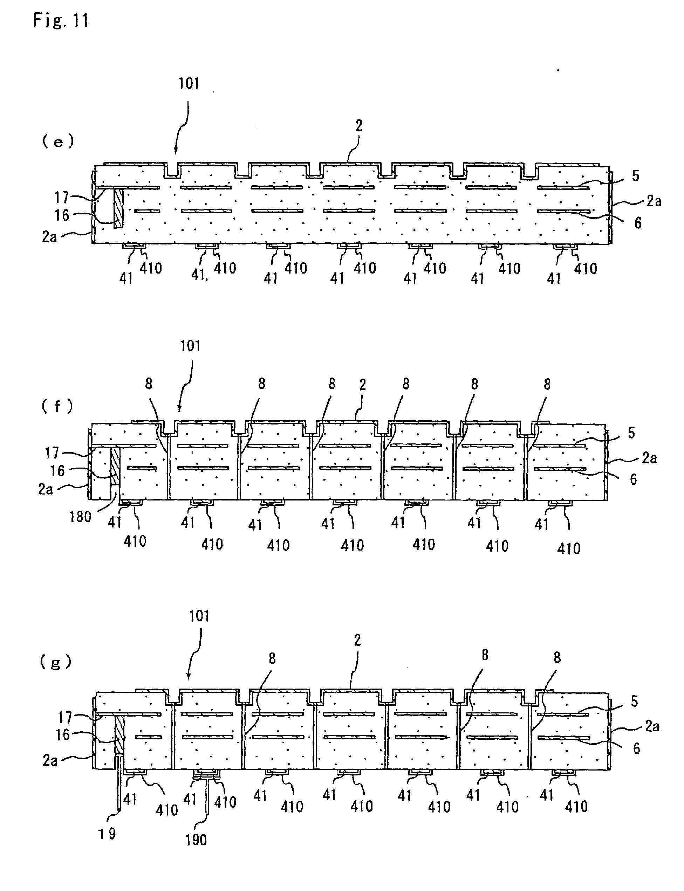

In the case where the heating element is provided on the surface of the ceramic substrate, the surface of the heating element is desirably covered with a metal layer 410 (refer to Fig. 11(e)). The heating element is a sintered body of metal particles. Thus, when the heating element is exposed, it is easily oxidized. This oxidization causes a change in the resistance value. Thus, by covering the surface with the metal layer, the oxidization can be prevented.

The thickness of the metal layer is desirably from 0.1 to 10 µm. This range is a range making it possible to prevent the oxidization of the heating element without changing the resistance value of the heating element.

The metal used for the covering is any non-oxidizable metal. Specifically, at least one selected fromgold, silver, palladium, platinum and nickel is preferred. Among these metals, nickel is more preferred for the following reason: the heating element needs to have a terminal for connection to a power source and this terminal is attached to the heating element through solder; in this case, nickel prevents thermal diffusion of the solder. As the connecting terminal, a terminal pin made of kovar can be used.

In the case where the heating element is inside a heater plate, the surface of the heating element is not oxidized. Therefore, no covering is necessary. In the case where the heating element is inside the heater plate, a part of the surface of the heating element may be exposed.

As the metal foil used as the heating element, a heating element patterned by the etching of a nickel foil or a stainless steel foil or by some other method is desirable.

The patterned metal foils may be put together with a resin film and the like.

Examples of the metal wire include a tungsten wire and a molybdenum wire.

In the case where a Peltier device is used as the temperature controlling means, both of heating and cooling can be attained by changing the direction along which an electric current flows. Thus, this case is advantageous.

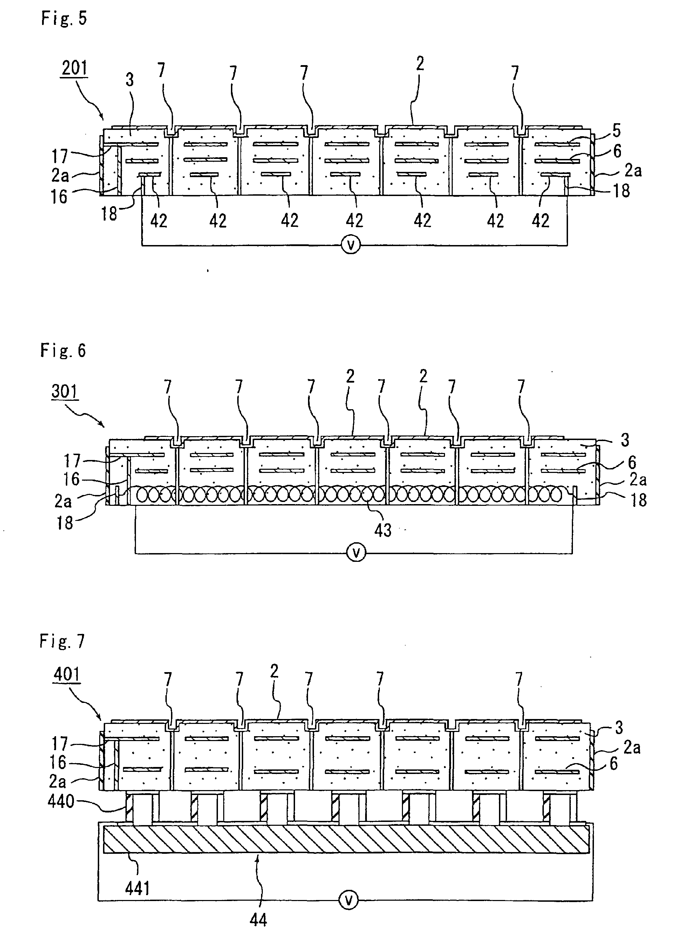

The Peltier device is formed by connecting p-type and n-type thermoelectric elements 440 in series and then jointing the resultant to a ceramic plate 441 and the like, as shown in Fig. 7.

Examples of the Peltier device include silicon/germanium type, bismuth/antimony type, and lead/tellurium type materials.

In the present invention, between the temperature controlling means and the chuck top conductor layer are formed the guard electrodes 5 and the ground electrodes 6.

The guard electrodes 5 are electrodes for canceling stray capacitors present in the measuring circuit. Grounding voltage of the measuring circuit (that is, the chuck top conductor layer 2 in Fig. 1) is given to the electrodes. The guard electrodes 5 and the side face conductor layer 2a connected to the guard electrodes 5 are formed to cancel noises from the temperature controlling means and the like.

The thickness of these electrodes is desirably from 1 to 20 µm. If the thickness is too small, the resistance value becomes high. If the thickness is too large, the ceramic substrate is warped or the heat shock resistance deteriorates.

These guard electrodes 5 and ground electrodes 6 are desirably formed in a lattice form, as shown in Fig. 4. That is, they desirably have such a shape that a lot of rectangular non conductor formed portions 52 are arranged inner portion of a circular conductor layer 51. The reason why such a shape is adopted is that the adhesion with the ceramics over and under the conductor layer is improved.

Examples of the material of the guard electrodes 5 and the ground electrodes 6 include metals and conductive ceramics used in the above-mentioned heating element.

In the face on which the chuck top conductor is formed of the wafer prober of the present invention, grooves 7 and air suction holes 8 are desirably formed as shown in Fig. 2. A plurality of suction holes 8 are formed, thus uniform adsorption is attained. This is because the silicon wafer W is put on the prober and air is sucked from the suction hole 8 to adsorb the silicon wafer W.

Examples of the wafer prober in the present invention include the wafer prober 101 wherein the heating elements 41 are formed on the bottom face of the ceramic substrate 3, and the layer of the guard electrodes 5 and the layer of the ground electrodes 6 are formed between the heating elements 41 and the chuck top conductor layer 2, as shown in Fig. 1; a wafer prober 201 having a structure wherein flat-shaped heating elements 42 are formed inside a ceramic substrate 3, and guard electrodes 5 and ground electrodes 6 are formed between the heating elements 42 and a chuck top conductor layer 2, as shown in Fig. 5; a wafer prober 301 having a structure wherein a metal wire 43, which is a heating element, is embedded in a ceramic substrate 3, and guard electrodes 5 and ground electrodes 6 are formed between the metal wire 43 and a chuck top conductor layer 2, as shown in Fig. 6; a wafer prober 401 having a structure wherein a Peltier device 44 composed of thermoelectric elements 440 and a ceramic substrate 441 is formed on the outside of a ceramic substrate 3, and guard electrodes 5 and ground electrodes 6 are formed between the Peltier device 44 and a chuck top conductor layer 2, as shown in Fig. 7; and the like. All of the wafer probers have a side face conductor layer 2a connected to the guard electrodes 5, grooves 7 , and suction holes 8. A reference numeral 17 represents a connection portion 17 for connecting the guard electrodes 5 to the side face conductor layer 2a.

As shown in Figs. 1 to 7, in the present invention, the heating elements 42 or 43 are formed inside the ceramic substrate 3 (Figs. 5 and 6) and the guard electrodes 5 and the ground electrodes 6 (Figs. 1 to 7) are formed inside the ceramic substrate 3. It is therefore necessary to form connection portions (conductor filled through holes) 16, 17 and 18 for connecting these to external terminals. The conductor filled through holes 16 and 18 are formed by filling a high melting point metal such as a tungsten paste or a molybdenum paste, or a conductive ceramic such as tungsten carbide or molybdenum carbide. It is advisable that the connecting portion 17 is formed in such a manner that when the guard electrodes 5 are formed, a part or all thereof are exposed outside.

The diameter of the connecting portions (conductor filled through holes) 16 and 18 is desirably from 0.1 to 10 mm since cracks or strain can be prevented while disconnection is prevented.

External terminal pins are connected, using the conductor filled through holes as connecting pads (refer to Fig. 11 (g)).

The connecting is performed using solder or brazing-material. As the brazing-material, brazing silver, brazing palladium, brazing aluminum, or brazing gold is used. As the brazing gold, Au-Ni alloy is desirable since Au-Ni alloy is superior in the adhesion to tungsten.

The ratio of Au/Ni is desirably [81.5 to 82.5 (% by weight)]/[18.5 to 17.5 (% by weight)].

The thickness of the Au-Ni layer is desirably from 0.1 to 50 µm. This is because this range is a range sufficient for keeping the connection. If Au-Cu alloy is used at a high temperature of 500 to 1000°C and at a high vacuum of 10⁻⁶ to 10⁻⁵ Pa, the Au-Cu alloy deteriorates. However, Au-Ni alloy does not cause such deterioration and is profitable. When the total amount of the Au-Ni alloy is regarded as 100 parts by weight, the amount of impurities therein is desirably less than 1 part by weight.

If necessary, in the present invention a thermocouple may be embedded in the ceramic substrate. This is because the thermocouple makes it possible to measure the temperature of the heating element and, on the basis of the resultant data, the voltage or electric current thereof is changed so that temperature can be controlled.

The size of the connecting portions of the metal wires of the thermocouple is equal to or more than the strand diameter of the respective metal wires, and is preferably 0.5 mm or less. Such a structure makes the heat capacity of the connecting portions small, and enables the temperature to be correctly and speedy converted to a current value. For this reason, the controllability of the temperature is improved so that the temperature distribution in the heated surface of the wafer becomes small.

Examples of the thermocouple include K-type, R-type, B-type, S-type, E-type, J-type and T-type thermocouples, described in JIS-C-1602 (1980).

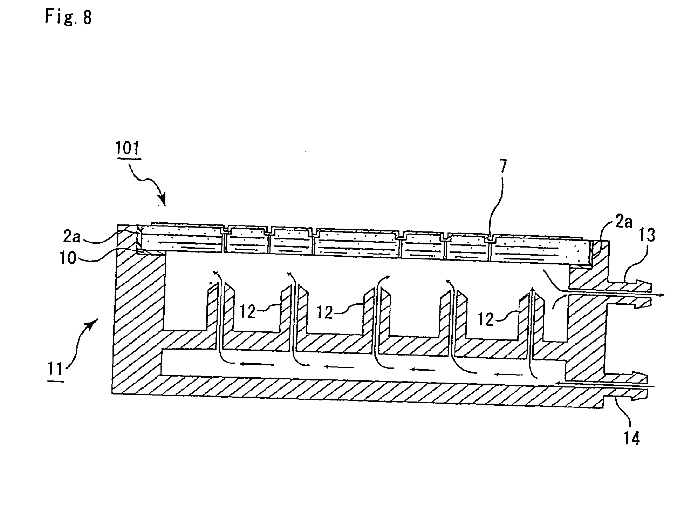

Fig. 8 is a sectional view which schematically shows a supporting case 11 into which the wafer prober of the present invention, having a structure as described above, is fitted.

Coolant outlets 12 are made in this supporting case 11, and a coolant is blown in from a coolant inlet 14. Air is sucked from a inhalation duct 13 to adsorb a silicon wafer (not shown) put on the wafer prober onto grooves 7 through the suction hole 8.

In the wafer prober of the present invention, a side face conductor layer 2a is formed on the side faces thereof. This side face conductor layer 2a is connected to guard electrodes 5 and earthed. On the other hand, in the case where the supporting case 11 is made of a metal such as aluminum alloy or stainless steel, by bringing the side face conductor layer 2a into contact with the supporting case 11, as shown in Fig. 8, this supporting case 11 is earthed. As a result, it is unnecessary to form special electrical wiring. The supporting case 11 may be made of a ceramic.

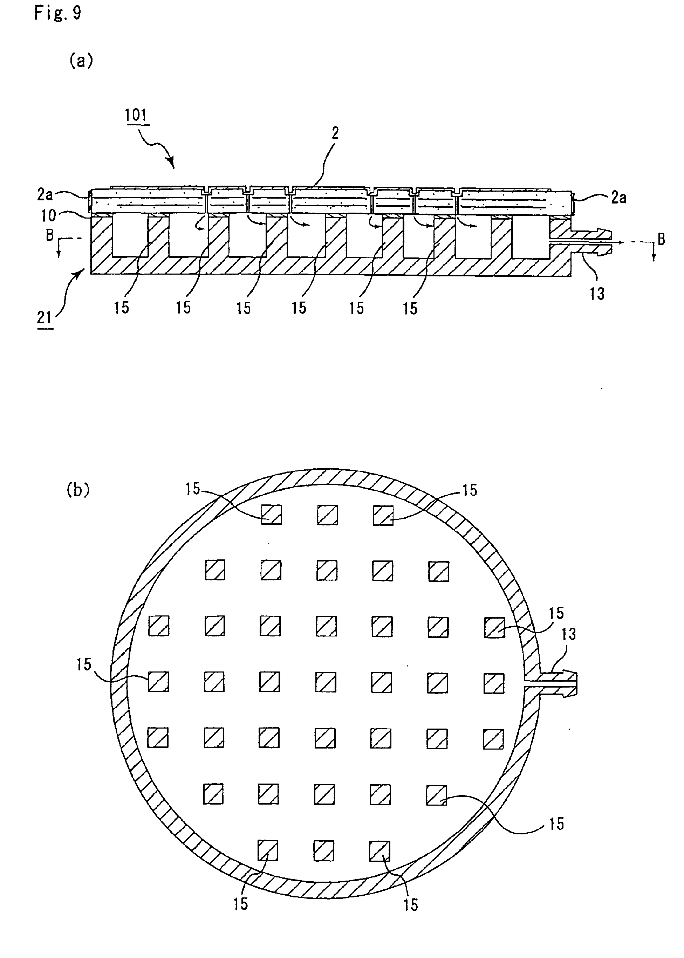

Fig. 9(a) is a horizontal sectional view which schematically shows another example of the supporting case. Fig. 9 (b) is a sectional view taken along B-B line in Fig. 9 (a). As shown in Figs. 9, numerous supporting columns 15 are formed so that a wafer prober is not warped by the pressing pressure of tester pins of a probe card.

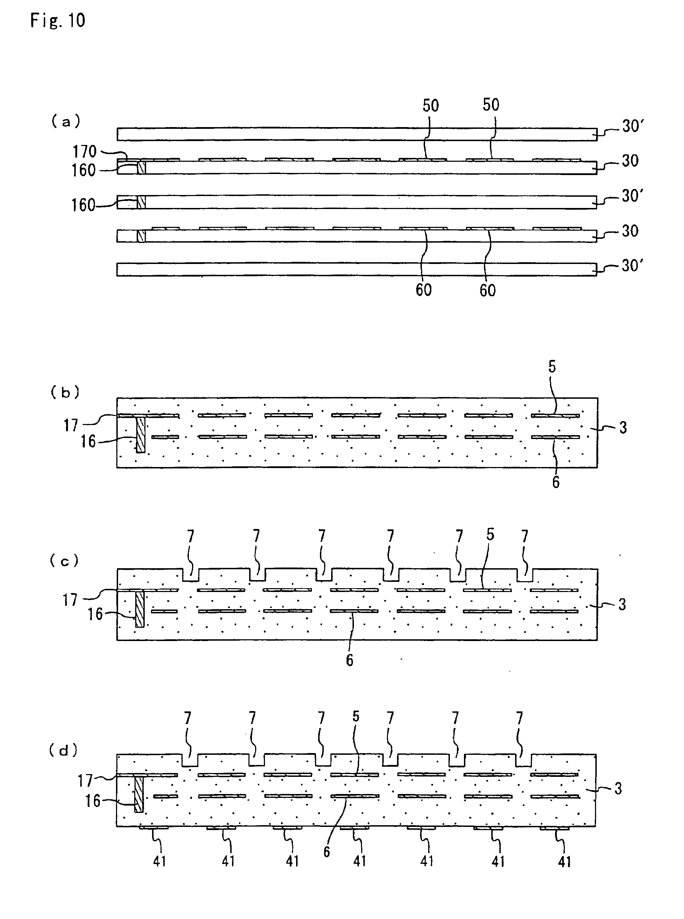

The following will describe an example of a process for producing a wafer prober of the present invention on the basis of sectional views shown in Figs. 10 and 11.

(1) First, ceramic powder of an oxide ceramic, a nitride ceramic, a carbide ceramic and the like is mixed with a binder and a solvent to obtain a green sheet 30.

As the ceramic powder, there may be used, for example, aluminum nitride or silicon carbide. If necessary, a sintering aid such as yttria and the like may be added thereto.

As the binder, desirable is at least one selected from an acrylic binder, ethylcellulose, butylcellosolve, and polyvinyl alcohol.

As the solvent, desirable is at least one selected from α-terpineol and glycol.

A paste obtained by mixing these is formed into a sheet form by a doctor blade process. Thus, a green sheet 30 is obtained.

If necessary, through holes into which supporting pins for a silicon wafer will be inserted and concave portions in which thermocouples will be embedded may be made in the green sheet 30. The through holes or the concave portions can be made by punching and the like.

The thickness of the green sheet 30 is preferably from about 0.1 to 5 mm.

Next, a conductor containing paste that will be guard electrodes and ground electrodes is printed on the green sheet 30.

The printing is performed to give a desired aspect ratio, considering the shrinkage ratio of the green sheet 30. In this way, a guard electrode printed body 50 and a ground electrode printed body 60 are obtained. A printed body 170 for connecting portions is fitted to the guard electrode printed body 50 in order to be connected to a side face conductor layer 2a, which will be formed on the side faces. A plurality of the printed bodies 170 for connecting portions may be formed in order to make sure the connection to the side face conductor layer 2a.

The printed bodies are formed by printing a conductor containing paste which includes conductive ceramic particles, metal particles and the like.

As the conductive ceramic particles contained in the conductor containing paste, carbide of tungsten or molybdenum is optimal. This is because they are not easily oxidized and their thermal conductivity is not easily lowered.

As the metal particles, for example, tungsten, molybdenum, platinum, nickel and the like can be used.

The average particle diameters of the conductive ceramic particles and the metal particles are preferably from 0.1 to 5 µm. This is because the conductor containing paste is not easily printed in either case where these particles are too large or too small.

As such a paste, the following conductor containing paste is optimal: a conductor containing paste prepared by mixing 85 to 97% by weight of the metal particles or the conductive ceramic particles; 1.5 to 10% by weight of at least one binder selected from acrylic, ethylcellulose, butylcellosolve and polyvinyl alcohol; 1.5 to 10% by weight of at least one solvent selected from α-terpineol, glycol, ethyl alcohol, and butanol.

Furthermore, the holes made by the punching were filled with a conductor containing paste to obtain a conductor filled through hole printed body 160.

Next, as shown in Fig. 10 (a) , the green sheets 30 having the printed bodies 50, 60, 160 and 170 and green sheet 30' having no printed bodies are made into a lamination. The reason why the green sheets 30' having no printed units are deposited on the side where heating elements will be formed is for preventing a phenomenon that end faces of conductor filled through holes will be exposed and oxidized at the time of sintering for the formation of the heating elements. If the sintering for the formation of the heating elements is performed in the state that the end faces of the conductor filled through holes are exposed, it is necessary to sputter a metal which is not easily oxidized, such as nickel. More preferably, the end faces may be covered with brazing gold made of Au-Ni.

(2) Next, as shown in Fig. 10 (b) , the lamination is heated and pressed to sinter the green sheets and the conductor containing paste.

Preferably, the heating temperature is from 1000 to 2000°C and the pressure is from 10 to 20 MPa (100 to 200 kg/cm²). The heating and the pressing are performed in an inert gas atmosphere. As the inert gas, argon, nitrogen and the like can be used. In this step, conductor filledthroughholes 16, connectingportions 17, guard electrodes 5, and ground electrodes 6 and the like are formed.

(3) Next, as shown in Fig. 10 (c) , grooves 7 are made in the top surface of the sintered body. Next, as shown in Fig. 10(d), a conductor containing paste is printed on the bottom face of the sintered body, and the resultant is fired to produce heating elements 41. The produced heating elements 41 adhere tightly to the surface of the ceramic substrate.

(4) Next, titanium, molybdenum, nickel and the like is sputtered onto the wafer-putting face (groove-formed face) and the side faces, and subsequently the resultant is subjected to electroless plating and the like, so as to form a metal layer wherein a chuck top conductor layer 2 and a side face conductor layer 2a are continuously formed. At the same time, a protective layer 410 is formed on the surface of the heating elements 41 by electroless plating and the like.

Subsequently, the boundary portion between the chuck top conductor layer 2 and the side face conductor layer 2a is removed by grinding, so as to divide the chuck top conductor layer 2 and the side face conductor layer 2a from each other, as shown in Fig. 11(e).

(5) Next, as shown in Fig. 11(f), suction holes 8, which penetrate from the grooves 7 to the bottom face, and blind holes 180 for connecting external terminals are made.

It is desired that at least one part of inner walls of the blind holes 180 is made conductive and the conductive inner walls are connected to the guard electrodes 5, the ground electrodes 6 and the like.

(6) At last, as shown in Fig. 11(g), a solder paste is printed on fitting sites of the heating elements 41 surface, and subsequently external terminal pins 190 are put thereon, heated and subjected to reflow. The heating temperature is preferably from 200 to 500°C.

External terminals 19 are fitted into the blind holes 180 through brazing gold. Furthermore, bottomed holes are made therein and thermocouples can be embedded in the holes if necessary.

As the solder, an alloy such as silver-lead, lead-tin or bismuth-tin can be used. The thickness of the solder layer is desirably from 0.1 to 50 µm. This is because this range is a range sufficient to maintain the connection based on the solder.

In the above description, the wafer prober 101 (refer to Fig. 1) is given as an example. In the case where the wafer prober 201 (refer to Fig. 5) is produced, it is advisable to print heating elements on a green sheet. In the case where the wafer prober 301 (Fig. 6) is produced, it is advisable that a metal foil or a metal wire is embedded, as guard electrodes and ground electrodes, in ceramic powder and then the resultant is sintered.

In the case where the wafer prober 401 (refer to Fig. 7) is produced, it is advisable that a Peltier device is jointed through a thermally sprayed metal layer.

### Best Modes for Carrying Out the Invention

The present invention will be described in more detail hereinafter.

### (Example 1) Production of a wafer prober 101 (refer to Fig. 1)

(1) The following composition was used to be shaped by a doctor blade process to obtain a green sheet of 0.47 mm in thickness: a composition obtained by mixing 100 parts by weight of aluminum nitride powder (made by Tokuyama Corp., average particle diameter: 1.1µm), 4 parts by weight of yttria (average particle diameter: 0.4 µm), 11.5 parts by weight of an acrylic binder, 0. 5 part by weight of a dispersant and 53 parts by weight of mixed alcohols of 1-butanol and ethanol.

(2) Next, this green sheet was dried at 80°C for 5 hours, and subsequently through holes for conductor filled through holes, for connecting heating elements and external terminal pins, were made by punching.

(3) The following were mixed to prepare a conductor containing paste A: 100 parts by weight of tungsten carbide particles having an average particle diameter of 1 µm, 3.0 parts by weight of an acrylicbinder, 3.5 parts by weight of α-terpineol solvent, and 0.3 part by weight of a dispersant.

The following were also mixed to prepare a conductor containing paste B: 100 parts by weight of tungsten particles having an average particle diameter of 3 µm, 1.9 parts by weight of an acrylic binder, 3.7 parts by weight of α-terpineol solvent, and 0.2 part by weight of a dispersant.

Next, a printed body 50 for guard electrodes, a printed body 60 for ground electrodes in a lattice form and a printed body 170 for connecting portions, were printed on the green sheet by screen printing using this conductor containing paste A.

Moreover, the conductor containing paste B was filled into the through holes for the conductor filled through holes for connecting the terminal pins.

The green sheets 30 on which the printing is performed and green sheets 30' on which the printing is not performed, the number thereof being 50, were laminated and then they were integrated with each other at 130°C and a pressure of 8 MPa (80 kg/cm²) to produce a lamination (refer to Fig. 10(a)).

(4) Next, this lamination was degreased at 600°C in nitrogen gas for 5 hours and hot-pressed at 1890°C and a pressure of 15 MPa (150 kg/cm²) for 3 hours to obtain an aluminum nitride plate 4 mm in thickness. The resultant plate was cut off into a disk of 230 mm in diameter to prepare a ceramic plate (refer to Fig. 10(b)). About the size of the conductor filled through holes 16, the diameter thereof was 3.0 mm and the depth thereof was 3.0 mm.

The thickness of the guard electrodes 5 and the ground electrodes 6 was 10 µm. The position where the guard electrodes 5 were formed was 1.2 mm from the wafer-putting face, and the position where the ground electrodes 6 were formed was 3.0 mm from the wafer-putting face.

(5) Next, a mask was put on the face, of the plate obtained in the (4), where a chuck top conductor layer would be formed, and blast treatment with SiC and the like was conducted to form concave portions (not shown) for thermocouples and grooves 7 (width: 0.5 mm, depth: 0.5 mm) for adsorbing a silicon wafer (refer to Fig. 10(c)).

(6) Furthermore, heating elements 41 were printed on the face opposite to the wafer-putting face. A conductor containing paste was used for the printing. The conductor containing paste was Solvest PS603D made of Tokuriki Kagaku Kenkyuzyo. This conductor containing paste was a silver/leadpaste, and contained 7.5 parts by weight of metal oxides consisting of lead oxide, zinc oxide, silica, boron oxide and alumina (the weight ratio thereof was 5/55/10/25/5) per 100 parts by weight of silver.

The shape of the silver was scaly and had an average particle diameter of 4.5 µm.

(7) The heater plate on which the conductor containing paste was printed was heated and fired at 780°C to sinter silver and lead in the conductor containing paste and further bake them on the ceramic substrate 3. The heater plate was immersed in a bath for electroless nickel plating consisting an aqueous solution containing 30 g/L of nickel sulfate, 30 g/L of boric acid, 30 g/L of ammonium chloride, and 60 g/L of a Rochelle salt, to precipitate a nickel layer 410 having a thickness of 1 µm and a boron content of 1% or less by weight on the surface of the silver sintered body 41. Thereafter, the heater plate was annealed at 120°C for 3 hours.

The heating elements 41 made of the silver sintered body had a thickness of 5 µm, a width of 2.4 mm and a volume resistivity of 7.7 mΩ/□ (Fig. 10(d)).

(8) By sputtering, a titanium layer, a molybdenum layer and a nickel layer were successively formed on the face at which the grooves 7 were made and on the side faces. The machine used for the sputtering was SV-4540 made by ULVAC Japan, Ltd. About conditions for the sputtering, air pressure was 0.6 Pa, temperature was 100°C and electric power was 200 W. Sputtering time was within the range of 30 seconds to 1 minute, and was adjusted dependently on the respective metals.

About the thickness of the resultant films, an image from a fluorescent X-ray analyzer demonstrated that the thickness of the titanium layer was 0.3 µm, that of the molybdenum layer was 2 µm and that of the nickel layer was 1 µm.

(9) The ceramic substrate obtained in the item (8) was immersed in a bath, for electroless nickel plating, consisting an aqueous solution containing of 30 g/L of nickel sulfate, 30 g/L of boric acid, 30 g/L of ammonium chloride, and 60 g/L of a Rochelle salt, and a bath, for nickel electroplating, containing 250 to 350 g/L of nickel sulfate, 40 to 70 g/L of nickel chloride, and 30 to 50 g/L of boric acid, the pH thereof being adjusted to 2.4 to 4.5 with sulfuric acid, so as to precipitate a nickel layer, having a thickness of 7 µm and a boron content of 1% or less by weight, on the surface of the metal layer made by the sputtering. Thereafter, the resultant was annealed at 120°C for 3 hours.

No electric current was not allowed to pass in the surface of the heating elements, thus the surface thereof was not coated with any electroplating nickel.

Furthermore, the ceramic substrate was immersed in an electroless gold plating solution containing 2 g/L of potassium gold cyanide, 75 g/L of ammonium chloride, 50 g/L of sodium citrate, and 10 g/L of sodium hypophosphite at 93°C for 1 minute to form a gold plating layer 1 µm in thickness on the nickel plating layer 15. Thereafter, grinding was performed by drilling, so as to remove the outer circumference of the face on which the grooves 7 for the extent of an area corresponding to 0.5 mm. In this way, a chuck top conductor layer 2 and a side face conductor layer 2a were formed (refer to Fig. 11(e)).

(10) Air suction holes 8 reaching the back surface from the grooves 7 were made by drilling, and then blind holes 180 for making conductor filled through holes 16 exposed were made (refer to Fig. 10(f)). Brazing gold made of Ni-Au (Au: 81.5% by weight, Ni: 18.4% by weight, and impurities: 0.1% by weight) was heated and subjected to reflow at 970°C to connect external terminal pins 19 made of kovar to the blind holes (refer to Fig. 11 (g)). External terminal pins 190 made of kovar were also formed through a solder (tin 9/lead 1) on the heating elements.

(11) Next, thermocouples for controlling temperature were embedded in the concave portions to obtain a wafer prober heater 101.

(12) This wafer prober 101 was put in a supporting case 11 made of stainless steel and which has a sectional shape of Fig. 8.

### (Example 2) Production of a wafer prober 201 (refer to Fig. 5)

(1) The following composition was shaped by a doctor blade method to obtain a green sheet 0.47 mm in thickness: a composition obtained by mixing 100 parts by weight of aluminum nitride powder (made by Tokuyama Corp., average particle diameter: 1.1 µm), 4 parts by weight of yttria (average particle diameter: 0.4 µm), 11.5 parts by weight of an acrylic binder, 0.5 part by weight of a dispersant and 53 parts by weight of mixed alcohols of 1-butanol and ethanol.

(2) This green sheet was dried at 80°C for 5 hours, and subsequently through holes for conductor filled through holes for connecting heating elements and external terminal pins were made by punching.

(3) The following were mixed to prepare a conductor containing paste A: 100 parts by weight of tungsten carbide particles having an average particle diameter of 1 µm, 3.0 parts by weight of an acrylic binder, 3.5 parts by weight of α-terpineol solvent, and 0.3 part by weight of a dispersant.

The following were also mixed to prepare a conductor containing paste B: 100 parts by weight of tungsten particles having an average particle diameter of 3 µm, 1.9 parts by weight of an acrylic binder, 3.7 parts by weight of α-terpineol solvent, and 0.2 part by weight of a dispersant.

Next, a printed body for guard electrodes, a printed body for ground electrodes, in a lattice form, and a printed body for connecting portions were printed on the green sheet by screen printing using this conductor containing paste A. Moreover, heating elements were printed into a concentrically circular pattern, as shown in Fig. 3.

The conductor containing paste B was also filled into the through holes for the conductor filled through holes for connecting the terminal pins.

The green sheets on which the printing is performed and green sheets on which the printing is not performed, the number thereof being 50, were laminated and then they were integrated with each other at 130°C and a pressure of 8 MPa (80 kg/cm²) to produce a lamination.

(4) Next, this lamination was degreased at 600°C in nitrogen gas for 5 hours and hot-pressed at 1890°C and a pressure of 15 MPa (150 kg/cm²) for 3 hours to obtain an aluminum nitride plate 3 mm in thickness. This was cut off into a disk 230 mm in diameter to prepare a ceramic plate. About the size of the conductor filled through holes, the diameter thereof was 2.0 mm and the depth thereof was 3.0 mm. The thickness of the guard electrodes 5 and the ground electrodes 6 was 6 µm. The position where the guard electrodes 5 were formed was 0.7 mm apart from the wafer-putting face, and the position where the ground electrodes 6 were 1.4 mm apart from the wafer-putting face. The position where the heating elements were formed was 2.8 mm apart from the wafer-putting face.

(5) Next, a mask was put on the face, of the plate obtained in the (4), where a chuck top conductor layer would be formed, and blast treatment with SiC and the like was conducted to form concave portions (not shown) for thermocouples and grooves 7 (width: 0.5 mm, depth: 0.5 mm) for adsorbing a silicon wafer.

(6) By sputtering, a titanium layer, a molybdenum layer and a nickel layer were formed on the surface in which the grooves 7 were made and on the side faces. The machine used for the sputtering was SV-4540 made by ULVAC Japan, Ltd. About conditions for the sputtering, air pressure was 0.6 Pa, temperature was 100°C and electric power was 200 W. Sputtering time was within the range of 30 seconds to 1 minute, and was adjusted dependently on the respective metals.

About the thickness of the resultant films, an image from a fluorescent X-ray analyzer demonstrated that the thickness of the titanium layer was 0.5 µm, that of the molybdenum layer was 4 µm and that of the nickel layer was 1.5 µm.

(7) The ceramic plate 3 obtained in the item (6) was immersed in a bath, for electroless nickel plating, consisting an aqueous solution containing of 30 g/L of nickel sulfate, 30 g/L of boric acid, 30 g/L of ammonium chloride, and 60 g/L of a Rochelle salt, so as to precipitate a nickel layer, having a thickness of 7 µm and a boron content of 1% or less by weight, on the surface of the metal layer made by the sputtering. Thereafter, the resultant was annealed at 120°C for 3 hours.

Furthermore, the ceramic substrate was immersed in an electroless gold plating solution containing 2 g/L of potassium gold cyanide, 75 g/L of ammonium chloride, 50 g/L of sodium citrate, and 10 g/L of sodium hypophosphite at 93°C for 1 minute to form a gold plating layer 1 µm in thickness on the nickel plating layer. Thereafter, grinding was performed by drilling, so as to remove the outer circumference of the face on which the grooves 7 were made for the extent of an area corresponding to 0.5 mm. In this way, a chuck top conductor layer 2 and a side face conductor layer 2a were formed.

(8) Air suction holes 8 reaching the back surface from the grooves 7 were made by drilling, and then blind holes 180 for making conductor filled through holes 16 and 17 exposed were made. Brazing gold made of Ni-Au (Au: 81.5% by weight, Ni: 18.4% by weight, and impurities: 0.1% by weight) was heated and subjected to reflow at 970°C to connect external terminal pins 19 and 190 made of kovar to the blind holes. The external terminal pins 19 and 190 may be made of W.

(9) Thermocouples for controlling temperature were embedded in the concave portions to obtain a wafer prober heater 201.

(10) This wafer prober 201 was put on a supporting case 21 made of stainless steel and which has a sectional shape of Fig. 9.

### (Example 3) Production of a wafer prober 301 (refer to Fig. 6)

(1) Electrodes in a lattice form were formed by punching a tungsten foil 10 µm in thickness.

Two of the lattice form electrodes (which would be guard electrodes 5 and ground electrodes 6, respectively) and a tungsten wire, together with 100 parts by weight of aluminum nitride powder (made by Tokuyama Corp. , average particle size: 1.1 µm) and 4 parts by weight of yttria (average particle size: 0.4 µm), were put in a mold, and then they were hot-pressed at 1890°C and a pressure of 15 MPa (150 kg/cm²) in nitrogen gas for 3 hours, so as to obtain aluminum nitride plate 3 mm in thickness. This was cut off into a disc 230 mm in diameter to prepare a plate. One end of the electrodes which would be the guard electrodes 5 was exposed to the outside, and connecting portions were set thereto.

(2) This plate was subjected to the steps (5) to (10) in Example 2, to obtain a wafer prober 301. In the same way as in Example 1, the wafer prober 301 was put on the supporting case 11 shown in Fig. 8.

### (Example 4) Production of a wafer prober 401 (refer to Fig. 7)

The steps (1) to (5) and (8) to (10) in Example 1 were carried out, and then nickel was thermally sprayed onto the face opposite to the wafer-putting face. Thereafter, a Peltier device made of lead/tellurium was jointed with it, so as to obtain a wafer prober 401. In the same way as in Example 1, the wafer prober 401 was put on the supporting case 11 shown in Fig. 8.

### (Example 5) Production of a wafer prober using silicon carbide as a ceramic substrate

A wafer prober was produced in the similar manner to that in Example 3 except the following matters and conditions.

That is, 100 parts by weight of silicon carbide powder having an average particle diameter of 1.0 µm were used, and the following were also used to be fired at a temperature of 1900°C: two electrodes in a lattice form (which would be guard electrodes 5 and ground electrodes 6, respectively) and a tungsten wire wherein a sol solution composed of 10% by weight of tetraethoxysilane, 0.5% by weight of hydrochloric acid and 89.5% by weight of water was applied to the surface thereof. In this way, a wafer prober 401 was obtained. In the same way as in Example 1, the wafer prober 401 was put on the supporting case 11 shown in Fig. 8. The sol solution turns into SiO₂ by firing, so as to compose an insulating layer.

### (Example 6) Production of a wafer prober using alumina as a ceramic substrate

A wafer prober was produced in the similar manner to that in Example 1 except the following matters and conditions.

A composition obtained by mixing 100 parts by weight of alumina powder (Tokuyama Corp. , average particle size: 1.5 µm), 11.5 parts by weight of an acrylic binder, 0.5 part by weight of a dispersant and 53 parts by weight of mixed alcohols of 1-butanol and ethanol was used to be shaped by a doctor blade process, to obtain a green sheet 0. 5 mm in thickness. The firing temperature was set to 1000°C.

In the similar manner to that in Example 1, the wafer prober obtained in Example 6 was put on the supporting case 11 shown in Fig. 8.

### (Comparative Example 1)

A wafer prober was produced in the similar manner to that in Example 1 except that the guard electrodes 5 and the side face conductor layer 2a were not formed.

### (Comparative Example 2)

A wafer prober was produced in the similar manner to that in Example 1 except that the side face conductor layer 2a was not formed.

### (Comparative Example 3)

A wafer prober was produced in the similar manner to that in Example 2 except that the side face conductor layer 2a was not formed.

### Evaluation Method

About each of the wafer probers produced in Examples 1 to 6 and Comparative Examples 1 to 3 put on the supporting cases, 1000 non-defective silicon wafers W were successively put thereon, as shown in Fig. 12. While the wafer prober was heated at 150°C, a probe card 601 was pressed against it to make a continuity test. In this manner, the generation rate of erroneous operations was examined. The results are shown in Table 1.

**Table 1**

| | Generation rate of erroneous operations (%) |
|---|---|
| Example 1 | 0 |
| Example 2 | 0 |
| Example 3 | 0 |
| Example 4 | 0 |
| Example 5 | 0 |
| Example 6 | 0 |
| Comparative Example 1 | 0.5 |
| Comparative Example 2 | 0.1 |
| Comparative Example 3 | 0.1 |

As is evident from Table 1, about the wafer probers according to Examples 1 to 6, precise determinations were made. However, about the wafer prober according to Comparative Example 1, wherein the ground electrodes were formed but neither guard electrodes nor side face conductor layers were formed, erroneous determinations were frequently made by noises. Also, about the wafer probers wherein no side face conductor layer was formed according to Comparative Examples 2 and 3, erroneous determination were made by noises in the same manner. However, the frequency of the erroneous determination was slight.

### Industrial Applicability

As described above, the wafer prober according to the present invention has a metal layer on a side face of a ceramic substrate, and the metal layer is connected to a guard electrode, whereby it is possible to protect a chuck top conductor layer against noises, to prevent integrated circuits and the like from erroneously operating due to the noises, and to precisely determine whether or not the integrated circuits and the like normally operate.

## Claims

1. A wafer prober comprising:
a ceramic substrate;
a chuck top conductor layer formed on a main face of said ceramic substrate; and
a guard electrode formed inside of said ceramic substrate, wherein
a metal layer is formed on a side face of said ceramic substrate.
